(19) Europäisches Patentamt
European Patent Office
Office européen des brevets

(11) Publication number: **0 452 114 A2**

## (12) EUROPEAN PATENT APPLICATION

(21) Application number: **91303173.8**

(22) Date of filing: **10.04.91**

(51) Int. Cl.5: **H01R 23/68, H05K 7/10**

(30) Priority: **13.04.90 JP 98328/90**

(43) Date of publication of application:
**16.10.91 Bulletin 91/42**

(84) Designated Contracting States:
**DE FR GB IT NL**

(71) Applicant: **TEXAS INSTRUMENTS
INCORPORATED
13500 North Central Expressway
Dallas Texas 75265 (US)**

(72) Inventor: **Tonooka, Takashi
1281 Takenoshita, Oyama-cho
Suntoh-Gun, Shizuoka (JP)**
Inventor: **Ikeya, Kiyokazu
187, Ueno Oyama-cho
Suntoh-Gun Shizuoka (JP)**

(74) Representative: **Abbott, David John et al
Abel & Imray Northumberland House 303-306
High Holborn
London, WC1V 7LH (GB)**

(54) Socket.

(57)    A socket having contacts to be engaged with leads of an IC chip during chip testing has contacts comprising one or more resilient, electrically conductive components embedded in and held within a body of elastic material which deforms with the electrically conductive components when engaged by an IC chip lead for cooperating with resilience of the electrically conductive components in holding the electrically conductive contact components in electrically conductive engagement with the IC chip lead with desired contact force.

EP 0 452 114 A2

FIG. 1

## Background of the Invention

This invention relates to a socket having a contact element which will be elastically compressed and electrically contacted with an electrical lead in connection with installation of a semiconductor integrated circuit (IC) chip into a socket for testing of the IC chip.

For carrying out a test on an IC chip (such as a heat-resistance test called the burn-in test), the IC chip is conventionally tested while inserted into a heating furnace for the determination of whether its performance is satisfactory or dissatisfactory under the furnace conditions. A test socket is used for IC chip installation during such a burn-in test and the socket is so constructed that a large number of pin-shaped contact elements are provided in the socket at the installation location in the socket where the IC chip is installed so that after the IC chip has been installed in the socket, those contact elements are connected to respective leads on the IC chip and may be electrically connected with a wired pattern in a printed circuit panel or plate which mounts the socket and chip while they are inserted into the furnace for testing.

The aforementioned contact element is ordinarily formed as a whole from an electroconductive material such as a copper alloy, or the like, the element typically comprising a fixed terminal having a lead leg part for fixing in a main socket body or base, an elastic curved part which is connected to this fixed terminal and is bent in a prescribed shape, and a compressing part which is connected to the distal or bent end of the curved part for the purpose of resiliently engaging and mounting the terminal against an outer lead part of an IC chip mounted in the socket.

For example, the aforementioned contact element typically comprises a so-called stamped contact which is blanked or shaped so as to possess a curved part of a prescribed shape as described above so as to obtain a desired resilience or elasticity in the contact element. If a prescribed compressive force (contact pressure) to an outer lead part of an IC chip is to be obtained using the conventional contact element as described, the curved part of the element tends to require sufficient length of arc in the prescribed shape to achieve that desired force with desired resilience. As a result that it typically becomes necessary, in terms of design, to utilize a size of contact element and to provide length of the contact in the height-wise direction of the contact element in particular which is longer than might otherwise be desired. Because of this, there is often an undesirable overall height in the socket which poses a serious problem in achieving high-density installation of IC chips etc., in a furnace for testing.

## Brief Summary of the Invention:

It is an object of this invention to provide a socket having an improved contact element design; and to provide such a socket capable of effecting high-density installation by reducing the size and particularly the height of the contact element in such a burn-in test socket while providing desired contact force between contact elements of the socket and IC chip leads.

Briefly described, the socket of this invention comprises a socket having a contact element having one or more electrically conductive components which can be electrically connected in an elastically compressed state to a prescribed lead of an IC chip installed in the socket, the aforementioned contact element components being embedded in and held in an elastic body which is discrete from the noted contact element components but which elastically deforms along with the contact element components to enhance the contact force with which the electrically conductive contact element component or components engage the IC chip leads.

## Description of the Drawings:

Other objects, advantages and details of the socket of the invention appear in the following detailed description of preferred embodiments of the invention, the detailed description referring to the drawings in which:

Figure 1 is a cross section of a socket according to the invention taken along line 1-1 of Figure 3;

Figure 2 is a partial cross section view along line 2-2 of Figure 3 showing the socket of Figure 1 with the installation of an IC chip on a carrier in the socket, Figure 3 showing the socket during the installation of an IC chip in a carrier into the socket;

Figure 3 is a slightly exploded perspective view shown the socket of Figure 1 while an IC chip installed in a carrier is being inserted into the main body of the socket;

Figure 4 is a partial perspective view of the socket of the invention while the chip carrier and the socket body are held fixed together by a retaining tool at four corners of the socket;

Figure 5 is a more fully exploded perspective view of the socket of Figure 1 indicating contact elements of the socket partly dismantled;

Figure 6 is a cross section view of another preferred embodiment of the invention;

Figure 7 is a partial cross section similar to Figure 6 showing the components of the contact element of Figure 6 elastically deformed;

Figure 8 is a partial cross section similar to Figure 4 wherein the chip carrier and the main body of the socket as well as the printed circuit panel or plate have been held and fixed together by a retaining tool at each of four corners of the socket (only one corner being shown); and

Figure 9 is a partial side elevation view of the structure of the contact element used in the socket shown in Figure 6.

## Description of the Preferred Embodiments:

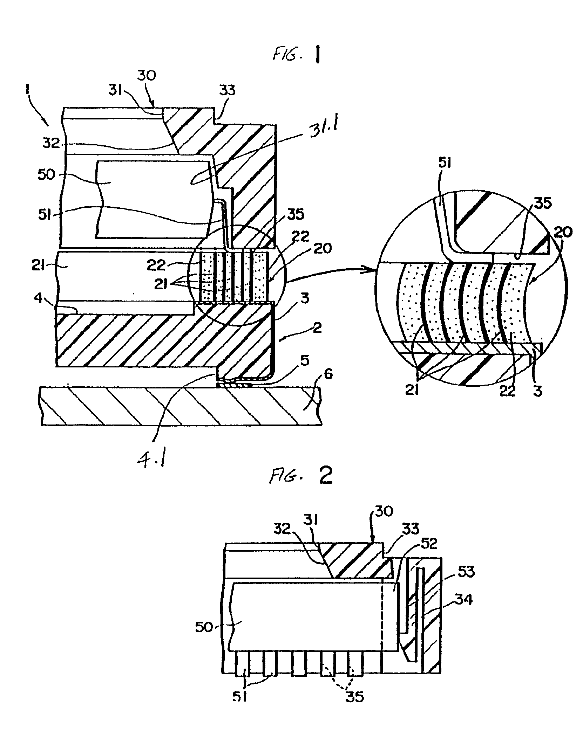

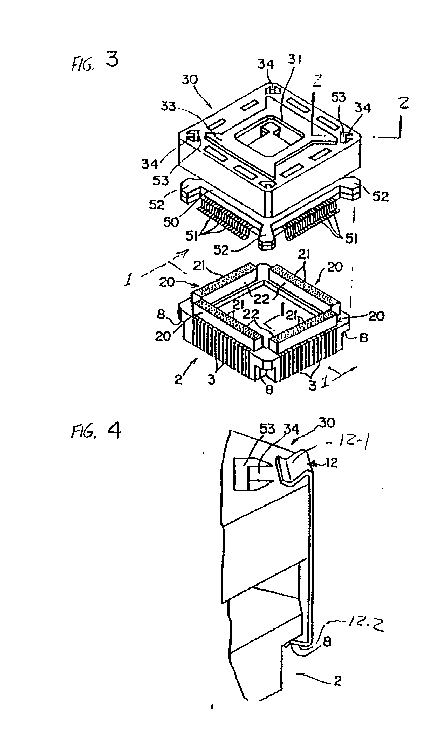

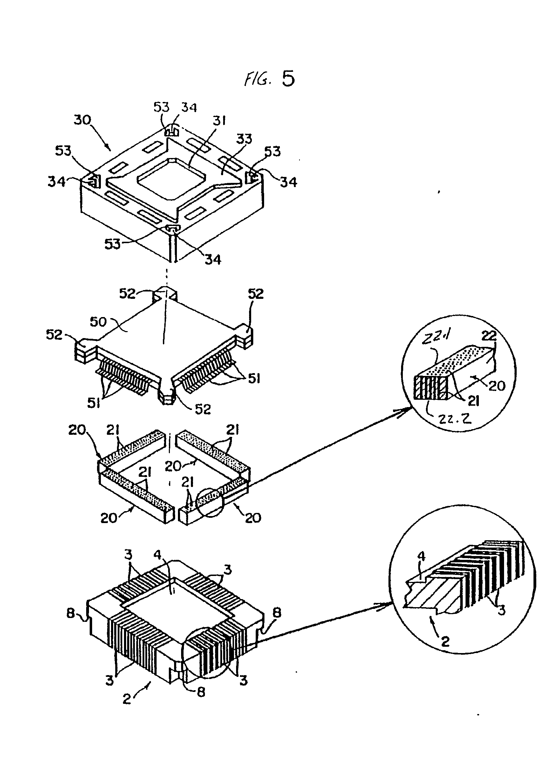

Referring to the drawings, 1 in Figures 1-5 indicates a preferred embodiment of the novel and improved socket of this invention. The socket is adapted for use in mounting an integrated circuit (IC) chip 50 and for electrically connecting leads 51 on the IC chip in a test circuit during burn-in testing of the IC chip. Such IC chips typically have a plurality of leads 51 disposed in spaced relation to each other along each of four sides of the chip and, as is shown particularly in Figures 3 and 5, the leads typically have a very small center-to-center spacing or pitch along each chip side. Typically the IC chips have protuberances or locating bosses 52 or the like arranged at the corners of the chip for example for use in detachably retaining the chips in chip carriers or mounting sockets and the like.

Typically for example a socket cover or chip carrier member 30 is arranged to support the chip on the socket. Preferably for example the carrier 30 has a central through hole 31 opening out by means of an inwardly facing, preferably inclined surface 32 into a larger cavity or hole portion 31.1 in the carrier at the bottom or lower side of the carrier hole as viewed in Figure 1. Preferably a concave part 33 of the carrier extends around the through hole 31, and the carrier is preferably formed by molding to include a hole 53 in each corner accommodating a resilient protuberant part or detent 34 of the carrier in each corner of the carrier. (See Figures 2 and 3.) Preferably also, the carrier is provided with a plurality of grooves 35 (see Figures 1 and 2) which are disposed in spaced relation to each other around inner walls of the cavity 31.1 and which extend outwardly along the bottom of the carrier, the grooves 35 having the same center-to-center spacing or pitch as the IC chip leads 51. In that arrangement, the carrier 30 accommodates the IC chip 50 within the cavity 31.1 with the IC leads 51 received in respective grooves 35, the grooves preferably having a sufficiently shallow depth so that portions of the leads 51 protrude from the grooves below the bottom or underside of the carrier as shown in Figures 1 and 2.

The socket 1 of the invention includes a main socket body 2, preferably of a relatively rigid electrically insulating material or the like, preferably having a central concavity or recess 4 on the top surface of the main body (as viewed in Figure 1). The body preferably has a similar concavity 4.1 on the bottom side of the main body. A plurality of contact parts 3 are provided in spaced relation to each other around the main body of the socket, the spacing of the contact parts 3 corresponding to the spacing or pitch of the IC chip leads. Preferably the contact parts are U-shaped as shown to extend across the top of the main socket body and the bottom of the main body at edges thereof around all four sides of the body. Preferably for example the contact parts 3 comprise plated-on contact parts formed by selective gold plating or the like. In that arrangement, the contact parts 3 of the socket are adapted to be soldered or otherwise electrically connected to respective printed circuit paths 5 or the like on a printed circuit board or panel 6 for mounting the socket thereon and for connecting the contact parts 3 in a desired test circuit or the like. Preferably the main body has cut-out portions or notches 8 located at the corners for example for use as described below.

The socket 1 further comprises contact elements 20 which are preferably disposed on the top surface of the main socket body and arranged to extend along each of four sides of the body. Each contact element is formed in large part by a member 22 of resiliently deformable, electrically insulating material such as silicon rubber or the like, preferably in the shape of a bar as shown in Figures 3 and 5. At locations within the elastically deformable member 22 corresponding to the locations of the contact parts 3, one or more electrically conductive metal components or filaments 21 are buried or embedded in spaced relation to each other within the deformable member in upstanding relation to extend between the top and bottom surfaces 22.1, 22.2 of the deformable member. Preferably the filaments are buried or embedded in the deformable member by being inserted endwise into the member material. Preferably for example five of the metal filaments 21 are arranged in a spaced relation to each other in a row as shown in Figure 1 at each location aligned with a contact part 3 on the socket body. Preferably each metal filament comprises a resilient copper or copper alloy material having gold plating thereon or the like, each metal filament being of relatively small diameter such that the five filaments spaced in each row are adapted to span a selected portion of the length of an IC chip lead 51. Preferably each filament or component 21 is somewhat protuberant from the top and bottom surfaces 22.1, 22.2 of the deformable member so that the protuberant ends of the filaments in each row at the bottom surface 22.2 are in electrically conductive engagement with the contact part 3 underlying the row of filaments and so that the protuberant ends of the filaments in each row at the top surface 22.1 are engaged with a respective IC chip lead 51. If desired, the contact elements are secured on the body 2 in the positions shown in Figure 3 by means of an adhesive (not shown) located between the body and end parts of the member 22 free of the filaments.

With the socket 1 constructed as above described, and with an IC chip 50 accommodated therein as above described, the carrier is preferably secured to the main socket body by clamp means 12 of the like for compressing the deformable member 22 of the contact elements and pressing the electrically conductive filaments 21 in engagement with contact parts 3 and IC chip leads 51 so that a row of the filaments electrically connects each IC lead to a corresponding contact part on the socket body as is shown in Figure 1. Preferably for example the clamp means comprises a U-shaped spring retaining clip 12 located at each corner of the socket body having an end 12.1 engaged with the carrier 30 and an end 12.2 engaged with the body 2 in a notch for example as shown in Figure 4.

At this juncture both the filaments 21 and the deformable members 22 of each contact element 20 are elastically deformed, whereby each lead part 51 of the IC chip is electrically connected to a corresponding contact part 3 on the socket body for electrically connecting the IC chip in the test circuit on the panel 6. Where the filaments 21 and deformable members 22 are both elastically deformed, they cooperate in holding the ends of the filaments in electrical engagement with the leads 51 and contact parts 3 with a contact force much greater than that provided by the filaments 21 alone. The deformable members also tend to support the filaments to hold the general shape of the filaments 21 during that elastic deformation. Accordingly it is possible to reduce the size of the filaments 21 both in diameter and in lengths to provide a very compact socket structure to achieve high density of sockets in a test furnace and high density of IC leads in each socket while also achieving desired levels of contact pressure engagement.

Accordingly, the present socket can cope with IC chips having an extremely small package structure, very small pitches of the outer leads in SOP (small out-line packages) and QPF (quad flat packages). Since the silicon rubber 22 retains the general shape of the contact element filament 21, it becomes easier to carry out deformation. In addition to this, there is an improvement in durability, making it possible to repeatedly use same.

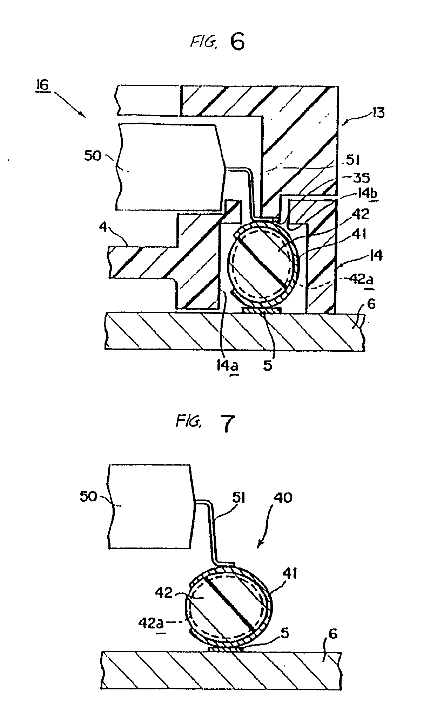

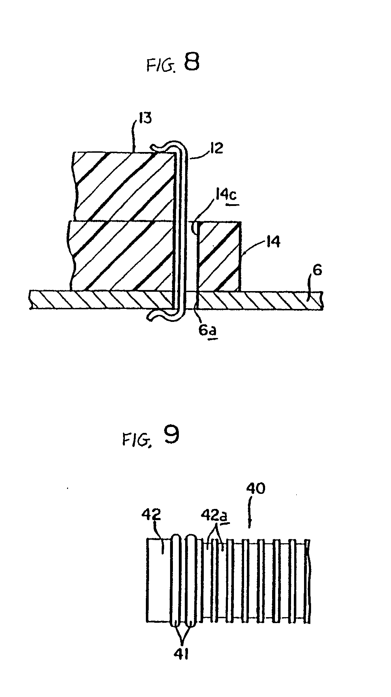

Figures 6 through 9 show other examples of the socket of this invention. Where the basic structure of the carrier and the main socket body for installation on the IC chip in Figures 6-9 are similar to the aforementioned example of Figures 1-5 for example, corresponding reference numeral are used.

As is shown in Figures 6 and 9, another preferred embodiment of the socket 16 of the invention has contact elements 40 corresponding to the contact elements 20. Each element 40 is formed by a generally cylindrical, elastically deformable silicon rubber number 42 which has grooves 42a provided therein at a prescribed pitch (the pitch being in conformity with the pitch of lead parts 51 of the IC chip 50) along the surface of the said silicon rubber member (see Figure 9).

Metal filaments 41 (contact element components) made of copper alloy, etc., are formed in the shape of C and are inserted in the grooves 42a, the grooves corresponding in number to the number of leads 51 along one side of the IC chip 50. As has been described above, the contact element 40 is arranged so that each contact element 41 in the silicon rubber member 42 electrically connects each IC chip lead 51 to a corresponding circuit pad 5, and contact element 41 is preferably fixed to the pad 5 on the printed base plate 6 by soldering or the like.

The socket 16 has a main socket body 14 and has an accommodating cavity or recess 14a provided for the accommodation of the contact elements 40 as shown in Figure 6. The IC chip 50 has a construction which is the same as described in the above example and it is so installed on the carrier 13 that its outer leads 51 may electrically engage the contact filaments 14 on the contact element 40 by means of a through hole 14b that has been formed in the cavity 14a of the socket 16.

In the state as described above, the socket 16 is provided on the printed base plate 6 and, as in the aforementioned example, the socket 16 is fixed on the printed base plate 6 at the prescribed locations at four corners of the socket 16. In other words, the upper surface of the carrier 13 and the lower surface of the printed base plate 6 are held and fixed by a spring clip or holding tool 12a which has been formed in the shape of U at the four corners of the socket 16 through the through holes 14c and 6a that are provided on the printed base plate 6 and the main socket body 14.

In the case where the socket 16 has been held and fixed onto the printed base plate 6 as described above, both the contact element 41 and the silicon rubber 42 are elastically deformed as described above, the outer lead parts 51 and the pads 5 on the printed base plate 6 are electrically connected through the contact element 40, and by reason of reaction force from compressing the elastically deformable filaments and members, the filaments 41 are in an elastically compressed state to provide a prescribed contact pressure as described above.

As has been explained above, the socket according to this example has a contact element 41 which is electrically connected in an elastically compressed state to the IC chip 50 when it should be installed, with the contact element 41 being held by a silicon rubber member 42 that also elastically deforms together with this contact element 41 but which is separate from this contact element 41. Accordingly, the size such as the height of the contact element 41, etc., can be reduced as in the previous example, with a consequence that the size of the socket as a whole can be reduced.

In the case of this example, further, the contact element 41 is formed in the shape of C by using a metal filament and retained generally in that shape by the member 41. Accordingly, it is convenient to obtain the prescribed compact pressure since the elasticity of the contact element 41 itself can be more effectively utilized.

Some examples of this invention have been described above; however, it is added that the aforementioned examples can further be modified on the basis of the technical concept of this invention.

For example, a metal filament made of copper alloy, etc., was used as the aforementioned contact element. It is possible to use, in addition to the above, other suitable materials such as electroconductive rubber, etc. Its shape, size and number etc., can further be modified. Suitable materials other than silicon rubber may also be used as the aforementioned elastic body and its shape, etc., can also be modified.

In addition, the structure for holding the contact element to the elastic body can also be modified without being restricted to what has been described above.

It is added that this invention can, of course, be used for the IC chips having various package structures as DIP (dual inline package).

As has been described above, this invention wherein the aforementioned electrically conductive contact element filament is held on an elastic body which is separate from the contact element filament but which elastically deforms along with the said contact element filament is capable of obtaining a prescribed compressive force by the elastic body that elastically deforms along with the contact element filament without relying on the compressive force based on the elasticity of the contact element filament as in the conventional art. Accordingly, it can offer a socket for high density installation by making it possible to reduce the size such as the height-wise direction of the contact element.

## Claims

1. A socket for mounting an integrated circuit chip to electrically connect a lead on the chip into an electrical circuit, the socket comprising a contact element having a deformable, electrically conductive metal component mounted on a member of elastically deformable material to resiliently press a portion of the metal component into electrical engagement with a chip lead with selected force and to support the metal component to retain the general shape thereof during such electrical engagement.

2. A socket for mounting an integrated circuit chip to electrically connect a plurality of leads on the chip into an electrical circuit, the socket comprising a body of electrical insulating material, a plurality of contact parts mounted on the body in spaced electrically insulated relation to each other to be electrically connected to respective leads on the chip and at least one contact element disposed on the body having a plurality of electrically conductive metal components mounted on a member of an elastically deformable material to resiliently press a portion of each metal component into electrical engagement with at least one contact part on the body and with at least one chip lead with selected force and to support the metal components to retain the general shapes thereof during such electrical engagement.

3. A socket according to claim 2 wherein the member of elastically deformable material is of a bar shape and the metal components comprise metal filaments embedded in the member in spaced electrically insulated relation to each other to extend through the member between opposite surfaces thereof.

4. A socket according to claim 4 wherein the metal filaments have ends which are protuberant from the opposite surfaces of the member of elastically deformable material to elastically engage contact parts on the body and chip leads.

5. A socket according to claim 2 wherein the member of elastically deformable material is of a generally cylindrical shape and the metal components comprise C-shaped metal filaments embedded in the member around a member periphery disposing portions of the filaments on opposite surfaces of the member to electrically engage contact parts on the body and chip leads at said opposite surfaces.

6. A socket for use in mounting an integrated circuit chip and electrically connecting a plurality of chip leads in an electrical circuit during burn-in testing of the chip comprising a body of electrical insulating material, a plurality of contact parts mounted on the body in spaced electrically insulated relation to each other along four sides of a top surface of the body, four contact elements each having a member of an elastically deformable, electrically insulating material and having a plurality of electrically conductive, resilient metal components mounted on the member in spaced, electrically insulated relation to extend between opposite surfaces of the member, the contact elements being disposed on the top surface of the body with the portions of the metal components at one surface of the member electrically engaging contact parts on the body, a carrier disposed over the contact elements for mounting an IC chip with leads thereof electrically engaging other portions of the metal components on the opposite surfaces of the elastically deformable members with chip leads, and means for clamping the carrier to the body for compressing the contact elements so that the member and metal components cooperate to resiliently press the metal components into electrical engagement with the contact parts and chip leads with selected contact force while the members support the metal components to retain their general shape during the electrical engagement.

7. A socket according to claim 6 wherein the member of elastically deformable material is of a bar shape and the metal components comprise metal filaments embedded in the member in spaced electrically insulated relation to each other to extend through the member between opposite surfaces thereof.

8. A socket according to claim 7 wherein the metal filaments have ends which are protuberant from the opposite surfaces of the member of elastically deformable material to electrically engage contact parts on the body and chip leads.

9. A socket according to claim 6 wherein the member of elastically deformable material is of a generally cylindrical shape and the metal components comprise C-shaped metal filaments embedded in the member around a member periphery disposing portions of the filaments on opposite surfaces of the member to electrically engage contact parts on the body and chip leads at said opposite surfaces.

FIG. 1

FIG. 2

FIG. 3

FIG. 4

FIG. 5

EP 0 452 114 A2

FIG. 6

FIG. 7

FIG. 8

FIG. 9

EP 0 452 114 A2